## Europäisches Patentamt

## European Patent Office

## Office européen des brevets

(19)

(11) Numéro de publication: **0 181 239 B1**

(12) **FASCICULE DE BREVET EUROPEEN**

(45) Date de publication du fascicule du brevet:
**17.05.89**

(51) Int. Cl.⁴: **G01R 19/17**, G01R 29/033

(21) Numéro de dépôt: **85401894.2**

(22) Date de dépôt: **27.09.85**

(54) Ensemble électronique de détection des variations fugitives d'une tension électrique en fonction du temps.

(30) Priorité: **05.10.84 FR 8415300**

(43) Date de publication de la demande:
**14.05.86 Bulletin 86/20**

(45) Mention de la délivrance du brevet:
**17.05.89 Bulletin 89/20**

(84) Etats contractants désignés:
**BE CH DE IT LI SE**

(56) Documents cités:
**GB-A- 2 094 010**
**US-A- 4 112 317**

**TELECOMMUNICATIONS AND RADIO ENGINEERING, no. 10, octobre 1966, pages 24-28, Washington, US; V.M. KOPP et al.: "A group channel impulsive noise analyzer for an HF telephony system used for data transmission"**

(73) Titulaire: **COMMISSARIAT A L'ENERGIE ATOMIQUE, 31/33, rue de la Fédération, F-75015 Paris(FR)**

(72) Inventeur: **Prulhiere, Jean-Paul, 33, Résidence "Le Grand Cèdre" Saint Avertin, F-37170 Chambray Les Tours(FR)**

(74) Mandataire: **Mongrédien, André et al, c/o BREVATOME 25, rue de Ponthieu, F-75008 Paris(FR)**

ACTORUM AG

**Description**

La présente invention se rapporte au domaine de l'examen de signaux électriques variables dans le temps, et, de façon plus précise, à la détection de variations fugitives et ponctuelles d'une tension électrique variable dans le temps. Un exemple de circuit se rapportant à ce domaine est décrit dans le document US-A 4 112 317.

Elle s'applique notamment, quoique de façon non limitative, à la surveillance des signaux émis par certains palpeurs utilisés en robotique pour le contrôle des cotes de pièces métalliques de formes diverses. Elle s'applique en particulier de façon très directe aux palpeurs à pression de contact nul, c'est-à-dire sans contact physique avec la pièce à contrôler, tels que celui qui a fait l'objet de la demande de brevet français n° 8025457 du 1er décembre 1981 publiée sous le no. FR-A 2 495 308 au nom du Commissariat à l'Energie Atomique.

Le signal électrique émis par un palpeur de ce genre, est une tension continue ou alternative qui peut à certains moments varier rapidement autour de sa valeur nominale et présenter des phénomènes significatifs que l'on désire déceler à coup sûr, tout en éliminant l'influence de parasites électriques toujours possibles.

En particulier, la tension électrique que l'on établit en robotique entre un palpeur et la pièce à tester subit des variations rapides lorsque le palpeur s'approche très près de la position de contact avec la pièce. Ces variations traduisent elles-mêmes des variations importantes du champ électrique entre le palpeur et la pièce, caractéristiques de l'approche de la pièce et ce sont elles que l'on désire précisément détecter à coup sûr, en les isolant, notamment de tout bruit de fond ou parasite.

La présente invention a précisément pour objet un ensemble électronique de détection de variations fugitives d'une tension électrique en fonction du temps spécialement adaptée à la solution de ce problème.

Cet ensemble se caractérise en ce qu'il comprend:

- un suiveur des variations de cette tension alimentant un système de filtrage et de redressement éliminant la composante continue du signal, et atténuant fortement, dans le domaine des hautes fréquences, les niveaux des signaux parasites ayant un caractère oscillatoire,

- un comparateur de cette tension ainsi filtrée et redressée, à un échelon de référence $V_2$, ledit comparateur délivrant une impulsion calibrée à chaque dépassement, par cette tension du seuil $V_2$,

- un circuit de comptage du nombre de ces impulsions calibrées durant un temps T donné, ledit ensemble de comptage fournissant un signal logique de détection des variations fugitives de la tension si ce nombre dépasse une quantité prédéterminée N.

Selon un mode de mise en oeuvre spécialement intéressant de la présente invention, l'ensemble électronique de détection comporte un circuit de comptage qui comprend une porte ET qui reçoit sur ses deux entrées respectivement le signal de sortie du comparateur et le signal d'une fenêtre de durée T et qui alimente en sortie un compteur par N alimentant une bascule bistable qui change d'état lorsque la tension électrique à surveiller présente des variations fugitives et qui fournit ainsi le signal logique de détection.

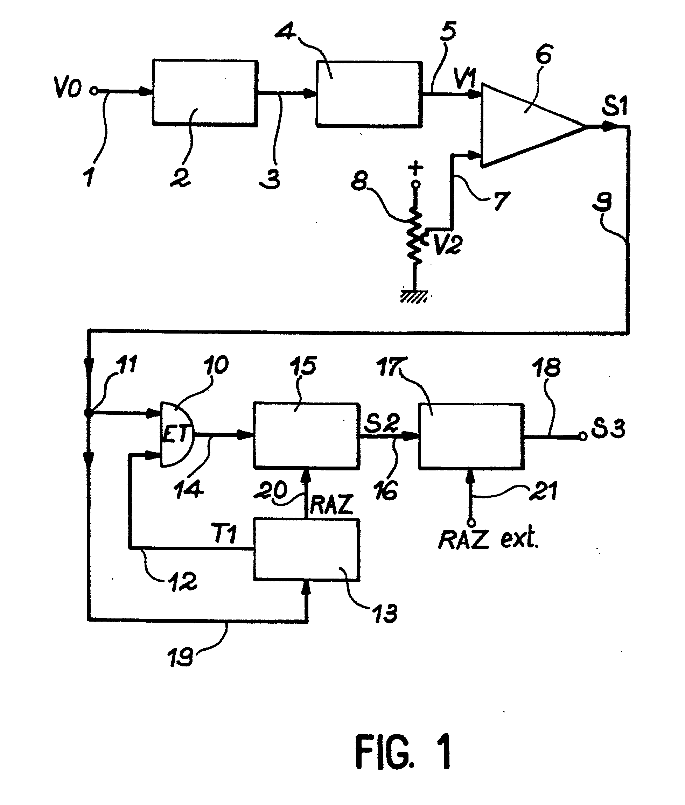

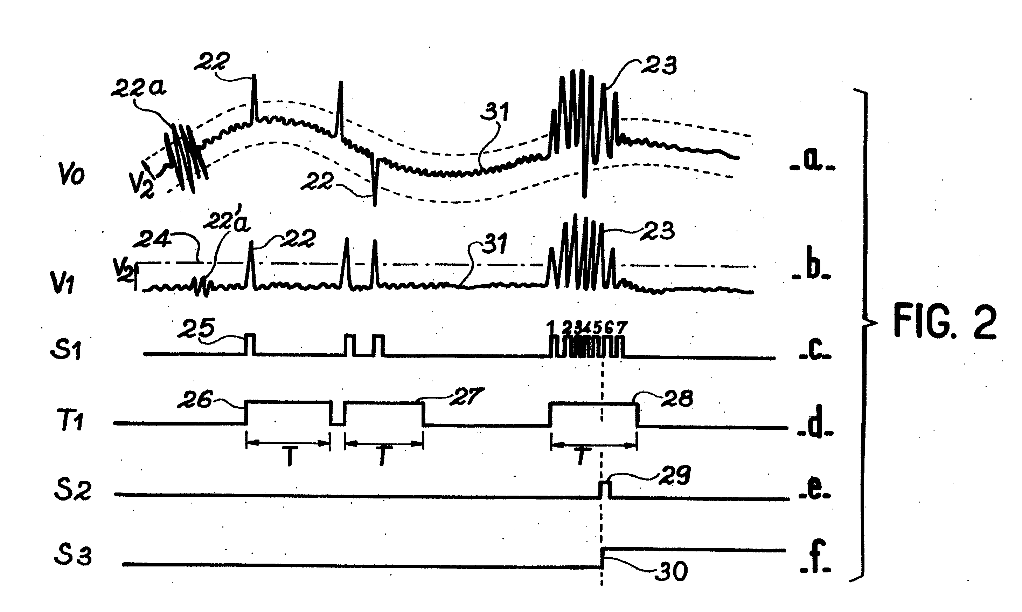

De toute façon, l'invention sera mieux comprise en se référant à la description qui suit d'un exemple de mise en oeuvre donné à titre illustratif et non limitatif en se référant aux figures 1 et 2 ci-jointes, sur lesquelles :

- la figure 1 est un schéma synoptique des principaux composants de l'ensemble électronique de détection objet de l'invention,

- la figure 2 montre sur ses différentes composantes 2a, 2b, 2c, 2d, 2e et 2f l'évolution en fonction du temps des signaux présents en différents points du schéma de la figure 1.

Sur la figure 1, on a représenté l'entrée 1 sur laquelle est appliquée la tension électrique continue ou alternative qui varie en fonction du temps et dont on veut surveiller les variations rapides intervenant éventuellement autour de sa valeur nominale. Conformément à l'invention, l'ensemble comprend un suiveur 2 des variations de cette tension qui est constituée dans l'exemple décrit par un amplificateur opérationnel à grande impédance d'entrée montée en suiveur. Le suiveur 2 envoie ensuite par la ligne 3 le signal dans un ensemble 4 comportant un filtre plus un redresseur dont la sortie 5 alimente la première entrée d'un comparateur 6 dont la seconde entrée 7 est alimentée par une source 8 de tension de référence $V_2$. Le fonctionnement de cette première partie de l'ensemble électronique, objet de l'invention est le suivant : le circuit 4 comporte un filtre passe-bande qui supprime la composante continue du signal et effectue le redressement de celui-ci selon l'une des alternances positive ou négative de celui-ci. Le comparateur 6 délivre sur sa sortie 9 des impulsions calibrées lors de chaque dépassement par la tension présente sur la ligne 5 du seuil de tension $V_2$.

Le reste du schéma de la figure 1 concerne le circuit de comptage du nombre de ces impulsions calibrées qui se situent dans une fenêtre de temps T donné. A cet effet, on trouve une porte ET, 10, recevant sur son entrée 11 le signal de sortie du comparateur 6 présent sur la ligne 9 et à son entrée 12 le signal d'une fenêtre temporelle de durée T engendrée par le circuit 13 de production d'une telle fenêtre. La sortie 14 de la porte 10 alimente un compteur par N, 15, dont la sortie 16 alimente à son tour une bascule bistable 17 dont la sortie est référencée 18.

Une liaison 19 relie l'entrée 11 de la porte ET, 10, et le circuit 13 ; deux commandes de remise à zéro du compteur et de la bascule sont également référencées 20 et 21.

Le fonctionnement de ce circuit de comptage et de l'ensemble électronique de détection, objet de l'invention sera maintenant expliqué en se référant à la figure 2.

Sur la figure 2a, on voit le signal $V_0$ tel qu'il est introduit sur l'entrée 1 du suiveur 2. Ce signal comporte un signal de valeur moyenne à basse fréquence 31 comportant des parasites tels que 22, des signaux parasites oscillatoires 22a et des phénomènes significatifs à identifier référencés 23.

A la sortie 5 du filtre et du redresseur 4, le signal $V_1$ a l'allure représentée sur la figure 2b où la composante moyenne à basse fréquence 31 est ramenée à une amplitude continue et où les parasites 22 et les phénomènes significatifs 23 sont redressés de façon à se situer toutes du même côté de la composante à basse fréquence 31. Sur cette même figure 2b, on voit en 24 le seuil de tension $V_2$ correspondant à la tension de référence au-dessus de laquelle on prend en considération les accidents du signal à surveiller. A la sortie 9 du comparateur 6, on trouve les signaux de la figure 2c pour lesquels des impulsions calibrées telles que 25 correspondent à chaque dépassement du seuil $V_2$ par la tension à étudier. Dans l'exemple décrit, le phénomène significatif 23 se décompose en sept pics correspondant, sur le signal de la figure 2c, à sept de ces signaux 25 référencés de 1 à 7.

A chaque apparition d'une impulsion 25, le circuit 13, informé par la ligne 19, envoie sur la ligne 12 à l'entrée de la porte ET, 10, une fenêtre sous forme d'un échelon de durée T comme on en voit en 26, 27 et 28 sur la figure 2d. Le compteur par N, 15, supposé réglé dans le cas décrit ici pour réagir lorsque N atteint ou dépasse le nombre de 6, déclenche sur la ligne 16 une impulsion 29 lorsque l'une des fenêtres 26, 27 ou 28 renferme plus de six impulsions calibrées. C'est le cas précisément pour la fenêtre 28 et le compteur 15 délivre alors sur la ligne 16 une impulsion 29 trahissant l'apparition de l'un des phénomènes significatifs que l'on veut surveiller. Pour compléter le dispositif, une bascule 17 transforme alors cette impulsion 29 en un changement d'état 30 présent en sa sortie sur la ligne 18 et caractéristique précisément de la variation de signal que l'on souhaite détecter.

L'ensemble électronique qui vient d'être décrit permet de détecter la présence d'une alarme en contrôlant la validité de celle-ci dans un ensemble qui peut comporter des parasites électriques divers. Il élimine les dérives lentes, les bruits de fond de ligne et les parasites électriques présents sur le signal à étudier.

Comme rappelé au début du présent texte, un tel ensemble électronique trouve une application particulièrement avantageuse dans la détection du contact entre une électrode et une surface dans la robotique de soudage. Il est bien entendu toutefois, que cette application n'est pas limitative et que d'autres domaines où il est nécessaire de traiter des signaux d'alarme peuvent être envisagés pour la présente invention.

## Revendications

1. Ensemble électronique de détection des variations fugitives d'une tension électrique en fonction du temps, caractérisé en ce qu'il comprend :

- un suiveur (2) des variations de cette tension alimentant un système de filtrage et de redressement (4) éliminant la composante continue du signal, et atténuant fortement, dans le domaine des hautes fréquences, les niveaux de signaux parasites ayant un caractère oscillatoire,

- un comparateur (6) de cette tension ainsi filtrée et redressée, à un échelon de référence $V_2$, ledit comparateur délivrant une impulsion calibrée (25) à chaque dépassement par cette tension du seuil $V_2$,

- un circuit de comptage (10, 15, 20) du nombre de ces impulsions calibrées durant un temps T donné, ledit ensemble de comptage fournissant un signal logique (30) de détection des variations fugitives de la tension si ce nombre dépasse une quantité prédéterminée N.

2. Ensemble électronique de détection selon la revendication 1, caractérisé en ce que le circuit de comptage comprend une porte ET (10) qui reçoit sur ses deux entrées (11, 12) respectivement le signal de sortie du comparateur (6) et le signal d'une fenêtre (13) de durée T et qui alimente en sortie un compteur par N (15) alimentant une bascule bistable (17) qui change d'état lorsque la tension électrique à surveiller présente des variations fugitives et qui fournit ainsi le signal logique (30).

## Patentansprüche

1. Elektronische Einheit zum Detektieren der flüchtigen Änderungen einer elektrischen Spannung in Abhängigkeit von der Zeit, dadurch gekennzeichnet, daß sie enthält:

– einen Verfolger (2) für die Änderungen dieser Spannung, der ein Filter- und Gleichrichtersystem (4) versorgt, das die Gleichkomponente des Signals eliminiert und im Bereich hoher Frequenzen die Pegel von Parasitärsignalen mit Schwingungseigenschaften stark dämpft,

– einen Komparator (6) für die so gefilterte und gleichgerichtete Spannung mit einem Bezugspegel $V_2$, welcher Komparator einen kalibrierten Impuls (25) immer dann liefert, wenn die Spannung die Schwelle $V_2$ überschreitet,

– eine Zählschaltung (10, 15, 20) für die Anzahl dieser kalibrierten Impulse während einer gegebenen Zeit T, wobei die genannte Zählanordnung ein logisches Detektorsignal (30) für die flüchtigen Änderungen der Spannung liefert, wenn diese Anzahl eine vorbestimmte Menge N überschreitet.

2. Elektronische Detektoreinheit nach Anspruch 1, dadurch gekennzeichnet, daß die Zählschaltung eine UND-Schaltung (10) enthält, die an ihren zwei Eingängen (11, 12) das Ausgangssignal des Komparators (6) bzw. das Signal eines Fensters (13) der Zeitdauer T erhält und die an hrem Ausgang mit einem auf N zählenden Zähler (15) verbunden ist, der eine bistabile Kippschaltung (17) speist, die den Zustand ändert, wenn die zu überwachende Spannung flüchtige Änderungen hat und die dann das logische Signal (30) abgibt.

## Claims

1. Electronic apparatus for detecting stray variations in an electrical voltage a sa function of time, characterized in that it comprises:

– a tracker (2) of the variations in this voltage supplied to a filtering and rectification system (4) which eliminates the continuous component of the signal and greatly diminishes the levels, in the high frequency range, of the parasitic signals having an oscillatory character,

— a comparator (6) comparing this voltage after filtering and rectification with a reference step $V_2$, said comparator furnishing a calibrated pulse (25) each time this voltage exceeds the threshold $V_2$; and

— a counting circuit (10, 15, 20) counting the number of these calibrated pulses during a given time period T, said counting device furnishing a logic signal (30) for detecting stray vibrations of the voltage if this number exceeds a predetermined quantity N.

2. Electronic detection apparatus as defined by claim 1, characterized in that the counting circuit includes an AND gate (10) which at its two inputs (11, 12) receives the signal of the output of the comparator (6) and he signal of a window (13) of duration T, respetively, and the output of which is applied to an N counter (15) supplying a bistable multi-vibrator (17) which changes its state whenever the electrical voltage to be monitored exhibits stray vibrations and which thus supplies the logic signal (30).

FIG. 1

FIG. 2

EP 0 181 239 B1